# EUROPEAN PATENT SPECIFICATION

(11) **EP 4 348 278 B1**
(45) Date of publication and mention of the grant of the patent: **01.04.2026**
(21) Application number: 21943973.4
(22) Date of filing: 02.06.2021
(51) Int. Cl.: G01M 3/40, G01R 31/12, G01R 31/16, G01R 19/165, G01R 31/52

(54) **APPARATUS AND METHOD FOR DETECTING HOLIDAYS IN LINERS**
VORRICHTUNG UND VERFAHREN ZUR DETEKTION VON LÖCHERN IN ABDICHTUNGSBAHNEN
APPAREIL ET PROCÉDÉ DE DÉTECTION DE FUITES DANS DES MEMBRANES D'ÉTANCHÉITÉ

(43) Date of publication of application: 10.04.2024
(73) Proprietor: Solmax International Inc., Varennes, Québec J3X 1P7 (CA)
(72) Inventor: YOUNGBLOOD, Jimmie, Gordon, Jr., Kingwood, TX 77345 (US)
(74) Representative: Dondi, Silvia
(86) International application number: PCT/IB2021/000399
(87) International publication number: WO 2022/254231

(56) References cited:
- CN-A- 112 748 315
- JP-A- 2002 333 433
- JP-A- 2020 051 993
- US-A- 3 970 924
- US-A- 4 241 304
- US-A- 5 302 904
- US-A1- 2015 003 480
- US-A1- 2016 370 415
- YOUNGBLOOD, J. ET AL.: "The Technical Background and Successful Field Experience of Spark Testing a Conductive Liner", GSE TE CHNICAL DOCUMENT, 2009, XP093013005, Retrieved from the Internet <URL:http://cheshmehtm.ir/wp-content/uploads/2015/05/FieldSTLeak-Location.pdf>

## Description

### FIELD OF THE INVENTION

A method and device for detecting holidays (punctures) in electrically insulating material.

### BACKGROUND OF THE INVENTION

Conventional holiday or puncture detection employs a device including a high voltage source connected to two or more electrodes located on the surface on the insulating layer. One electrode is swept along the tested surface and, when a holiday in the insulating layer is encountered, a spark jumps from the electrode to the puncture. A detection mechanism identifies any spark event and typically signals the operator (*e.g.,* by an audible sound and/or visual indication) who can then note the location of the electrode as being the location of a holiday.

The high voltage source has been a direct current (DC) or alternating current (AC), though typically the voltage has been pulsed (AC) with each pulse achieving the highest voltage during a short time interval. The source of high voltage has typically been pulsed at a rate sufficiently fast to ensure the test area is covered while the electrode is pulled or pushed by the user. Particularly with AC pulses, the detection mechanism must be able to reliably differentiate a normal pulse discharge (no holiday) from a spark (holiday), with such differentiation typically having been based on changes in the current or voltage amplitude sensed during the absence and the presence of a spark.

Unfortunately, conventional detection mechanisms oftentimes have had difficulty detecting a holiday reliably. Those mechanisms are sensitive to changes in current flowing in the cable from the pulse generator to the brush (versus time), and operate based on inductive coupling which is not sensitive to changes in electric charge. Holidays cause a transient in the current and electric charge built around the electrodes. Since the current in the cable is proportional to the impedance between the brush and the liner, when a holiday is encountered the impedance changes instantaneously and the amplitude of the sensed current reflects that change. Such detection mechanisms determine whether the peak current amplitude exceeds a threshold indicative of a holiday and, when the threshold is exceeded, generate an audible sound and/or visual indication to indicate that the electrode is located at a holiday.

However, similar current changes can result from impedance changes which occur for reasons other than a spark, and such impedance changes can be indistinguishable from those resulting from a holiday, For example, when the electrode is swept across the insulating surface, there are instantaneous variations in the current or voltage imparted to the electrodes, and those normal variations have frequently been flagged as holidays even if there is no spark or puncture in the insulating surface or liner. Additionally, changes in ground conductivity in the soil underneath the liner cause variations that have misled detection mechanisms into producing false positives (false indications of a spark/puncture).

Conventional holiday detectors have permitted the user/operator to manually adjust the level of sensitivity *(i.e.,* the peak current amplitude threshold chosen to indicate a spark) in order to minimize false positives. However, such adjustments do not fully address false positives and false negatives. That is, while the threshold can be manually adjusted, such adjustments are only approximations of the appropriate threshold over an area. Thus, while the threshold may be adjusted to ensure that the detector is sensitive enough to signal a positive where a holiday is known to exist but not so sensitive as to signal a positive where a holiday is known not to exist, such a threshold may not be appropriate in other areas of the liner where different conditions exist (*e.g.,* different ground detectivity, brush contact changes). In short, when detecting for holidays in a liner, even a selection of a threshold which functions well over an area of a liner may be poorly suited for other areas, resulting in holidays being missed and/or holidays being indicated where no holiday exists.

Document JP 2020 051993 A discloses an inspection system comprising an electrode brush for spark inspections. The electrode brush may have bristles or may in roll shape so as to detect defective position even in case of unevenness.

A flexible Neoprene electrode for spark testing is shown in the scientific paper titled *"*The Technical Background and Successful Field Experience of Spark Testing a Conductive Liner" by J. Youngblood et al., GSE Technical Document, 2009.

The apparatus and method disclosed herein significantly overcome the above described disadvantages of the prior art.

### SUMMARY OF THE INVENTION

The presently claimed solution is set out in the appended set of claims. A method and apparatus for holiday detection in electrically insulating surfaces is disclosed herein. The apparatus is a portable device including a high voltage generator, at least two moving electrodes delivering a charge to the liner, and a detection mechanism capable of identifying holidays under a wide range of variable environmental or operating conditions, either due to motion of the electrode, variable soil resistivity or others. The holiday detector uses smart signal processing to minimize environmental variability and accurately flag holidays without requiring manual adjustments.

One aspect of the disclosure is a method of detecting holidays in a liner according to claim 9, comprising the steps of (a) creating a circuit for current from a generator to a first contact with the liner to a second contact spaced from the first contact to the generator, the second contact being an electric reference for the generator, (b) pulsing current from the generator to the liner first contact as the first contact is moved over the liner, (c) detecting a plurality of at least one electric signal associated with the pulsing current from the electric reference, (d) continuously processing a selected recent plurality of the detected electric signals to generate a baseline value for the at least one electrical signal, wherein a detected electric signal having a value on one side of the baseline is deemed to indicate no holiday and an electric signal having a value on the other side of the baseline is deemed to indicate a holiday, and (e) actuating a holiday signal when at least one of the detected electric signals has a value on the other side of the baseline.

In another aspect of the disclosure, a sensor for detecting holidays in a liner according to claim 1 includes a pulsing generator with an electrical reference, an electrode adapted to move over and maintain contact with the liner spaced from the generator electric reference while the generator pulses current to the electrode, a processor, and a holiday signal actuated when any detected electric signal has a value on the other side of the baseline. The processor is adapted to detect over time from the generator electric reference at least one electric signal associated with the pulsing current, continuously process for a recent selected time period the at least one electric signals detected during the selected time period, and generate a baseline of the at least one electrical signal, wherein a detected electric signal having a value on one side of the baseline is deemed to indicate no holiday and an electric signal having a value on the other side of the baseline is deemed to indicate a holiday.

The processor is adapted to detect both current strength and voltage, continuously process current strength to generate a baseline of current strength, and continuously process voltage to generate a baseline of voltage. The holiday signal is actuated when either of the detected current strength or detected voltage is on the other side of its generated baseline.

In still another form of this aspect of the disclosure, the processor is adapted to use at least one of energy averaging, filtering, and Fourier spectrum to generate the baseline from the recent plurality of detected electric signals.

In yet another form of this aspect of the disclosure, the actuated holiday signal is at least one of an audible sound and a warning light.

In still another form of this aspect of the disclosure, the holiday signal is a location indication corresponding to the area of the liner being contacted by the electrode at the time the detected electric signal value is on the other side of the baseline.

In one form of this aspect of the disclosure, the contact is a flexible conductive sheet.

In another form of this aspect of the invention, the contact is flexible chain mail.

In still another form of this aspect of the invention, the contact includes a truck rolling on guide wheels, a flexible conductive cable supported between the guide wheels, and a plurality of conductive rollers spaced along the cable wherein each roller is rotatable about the cable.

Other objects, features, and advantages of the invention will become apparent from a review of the entire specification, including the appended claims and drawings.

### BRIEF DESCRIPTION OF THE DRAWINGS

Figure 1 is an illustration of a prior art sensor used to detect holidays on a liner;
Figure 2 is an illustration of an electrode brush used with prior art sensors such as in Fig. 1;
Figure 3 is a cross-sectional illustration of a grounding pad and liner laid on soil as used with prior art liners and sensors such as illustrated in Fig. 1;
Figure 4 is an illustration of a new sensor disclosed herein and used to detect holidays on a liner;
Figure 5 is an illustration of a new movable contact for sensors used to detect holidays on a liner;
Figures 6A and 6B are alternative movable contacts for sensors used to detect holidays on a liner;
Figure 7 is an illustration of an electromagnetic detector such as may be used with the sensor of Fig. 4;
Figure 8 is an illustration of an alternative embodiment of a holiday sensor wherein both current and voltage may be detected to determine the presence of a holiday;
Figure 9 illustrates a sample waveform of detected current showing the threshold used with the prior art sensors versus the threshold as determined by the new sensors disclosed herein; and
Figure 10 is a flow chart showing the operation of a new sensor such as disclosed herein which measures both current and voltage amplitudes and uses such measured amplitudes to dynamically determine thresholds for each indicative of the presence of a holiday.

### DETAILED DESCRIPTION

As described in detail below, a new apparatus and method for identifying liner holidays is disclosed including a generator having two contacts with a liner, with the generator pulsing current to a moving one of the contacts. The pulsing current is continuously processed to continuously generate a baseline indicative of a holiday. Additionally, a plurality of detected electric signals, such as current strength and voltage, may be so processed to continuously generate baselines for each signal indicative of a holiday, where a holiday signal is actuated when any signal is detected which when compared to its generated baseline indicates a holiday. The moving contact may be flexible to conform to contour of the liner.

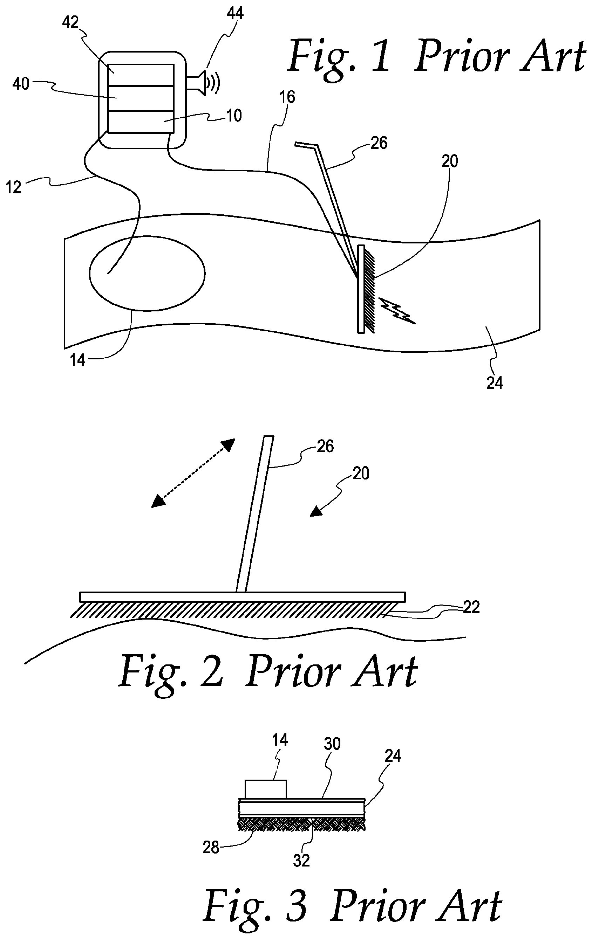

As further background to the disclosure, Figs. 1-3 herein provide greater detail regarding a prior art apparatus upon which the apparatus and method disclosed herein improves.

Specifically, Fig. 1 illustrates a detecting apparatus defining a circuit in which a high voltage generator 10 has a first cable 12 connecting to an electrode or grounding pad 14 and a second cable 16 connected to a movable electrode or conductive brush 20. In use, the apparatus grounding pad 14 *(i.e.,* electric reference, such as a ground) is connected to the top of the liner 24 being tested, and the electrode brush 20 is moved over areas of the liner 24. The generator 10 has provided a constant current or in some versions has generated high voltage pulses.

The grounding pad 14 serves as a capacitive plate to couple electrical energy into the liner 24. However, it should be understood that the grounding pad 14 could in some applications be placed on the ground and not on the liner 24 *(i.e.,* the grounding pad 14 could be placed on the ground or land outside of the boundaries of the liner 24).

The brush 20 has typically been made of metallic bristles 22 which form an electrode to impart high voltage on the liner 24, where in the presence of a holiday a spark is generated. A nonconductive handle 26 is attached to the brush 20 and allows the user to sweep the brush 20 across the liner 24 for testing. However, as illustrated in Figs. 2, the stiff bristles of the brush 20 have been susceptible to variations in contacting the liner 24, particularly where the liner contour is not flat.

As illustrated in Fig. 3, liners 24 such as geomembranes typically lie on soil 28 and are intended to be impermeable, with an insulating top layer 30 and a conductive bottom layer 32. The circuit of the apparatus will flow from the brush 20 through the liner 24 to the grounding pad 14. It should be appreciated that such current flow will be affected if the brush 20 contacts an area of the liner 24 having a holiday, as rather than being limited to flowing along the insulating top layer 30 the current may flow through the holiday and then along the conductive bottom layer 32.

Such prior art apparatuses have included a detector 40 in the circuit for detecting current flow, and a comparator 42 which compares the signal to a threshold taken to be indicative of a holiday. For example, if the current strength spikes to a value above the threshold, that would be taken to indicate a holiday *(i.e.,* wherein the spiked strength indicates flow through the liner conductive bottom layer). However, as previously noted, while a spike of current flow could be indicative of a holiday, it could also result from other factors, such as instantaneous variations in the current or voltage imparted to the electrodes and changes in ground conductivity in the soil underneath the liner (depending on, *e.g.,* soil type and humidity). Other factors could include, for example, abrupt changes in the motion of the brush 20 and/or abrupt changes in the extent of contact between the brush 20 and liner 24.

The threshold used by the comparator 42 has been set manually, whether based on operator experience or by initially testing current strength at areas where it is known that there is no holiday and/or where one is known. Once testing begins, the threshold has been set for the entire tested area, though the operator may manually change the threshold if it is determined that the threshold is inappropriately returning false positives (indicating a holiday where there is none) or false negatives (not recognizing a holiday where one exists).

An audible alarm 44 has alerted the operator when the detected electrical signal passes the threshold as is indicative of the brush 20 being located at a holiday.

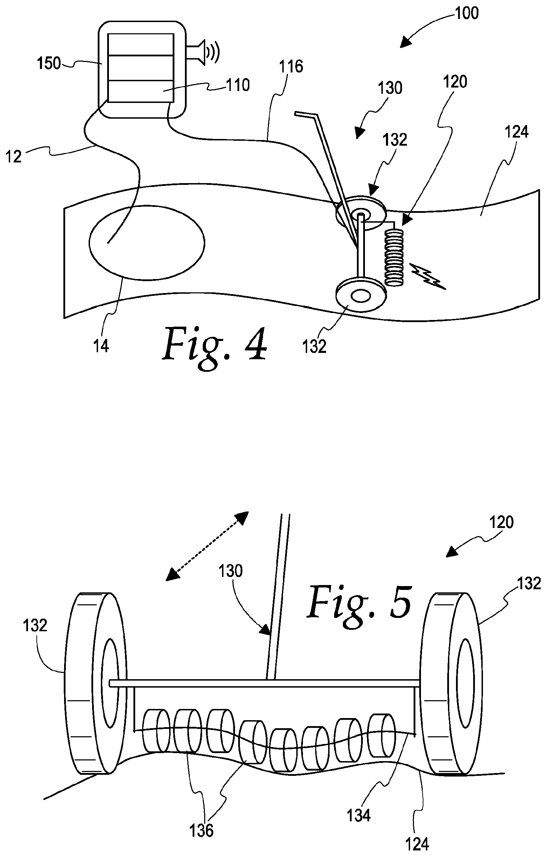

The improved apparatus and method disclosed herein is illustrated beginning with Fig. 4. That is, as illustrated in Fig. 4 and described in more detail herebelow, the sensor 100 for identifying holidays in liners 124 includes an improved movable electrode or contact 120 which maintains a uniform contact with unevenly contoured liners 124. Further, as also illustrated and described in more detail herebelow, a high voltage generator 110 generates a signal which is advantageously processed in the sensor 100 in a manner which greatly reduces false positive and false negatives.

Specifically, as shown in Figs. 4-5, the movable contact 120 includes a truck 130 rolling on guide wheels 132 with a flexible conductive cable 134 supported between the guide wheels 132. A plurality of conductive rollers 136 are spaced along the cable 134 wherein each roller 136 is rotatable about the cable 134. As illustrated, given the flexibility of the cable 134, all the rollers 136 will contact the liner 124 even in areas which are not flat but have rolling contours.

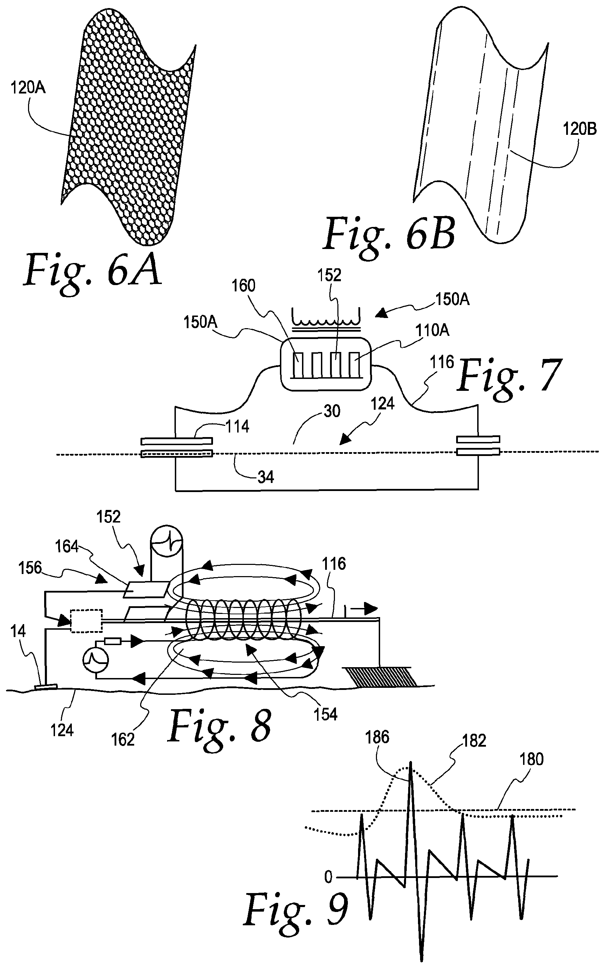

Still other variations for the movable contact include materials which are flexible, surface conforming, and conductive, such as chainmail 120A illustrated in Fig. 6A and a flexible conductive film 120B (*e.g*., conductive neoprene) illustrated in Fig. 6B which can be dragged across the liner 124.

Further, referring to Fig. 4 and the improvement disclosed herein, the sensor 100 also includes a holiday detector unit 150 which includes a high voltage generator 110. Further, the high voltage generator is a high voltage *pulse* generator 110A (see Fig. 7) whereby the holiday detector unit 150A determines the holiday baseline measurement *dynamically* as discussed in further detail below.

Referring now to Fig. 8, the detector unit 150 in another aspect of the disclosure may advantageously include an electromagnetic detector 152 (see Fig 7) which senses not only current traveling through the high voltage cable 116 but the energy (voltage and current) from the high voltage generator 110. An electromagnetic detector 152 is more sensitive than current detectors used in prior art systems, and thus is less susceptible to false positive and false negative signals.

Further, an electromagnetic detector 152 such as illustrated in Fig. 8 may be advantageously used with a high voltage pulse generator 110A. The electromagnetic detector 152 is a combination of magnetic (inductive) coupler 154 and electric (capacitive) coupler 156 which senses the energy variation taking place in the high voltage pulse generator 110A. The electromagnetic detector 152 is sensitive to changes in current flowing in the high voltage cable 116 and to changes in electric charge between the electrode (*e.g.,* Figs. 5, 6A, 6B) and the liner 124. A processor 160 compares the sensed signals to thresholds for each signal (*e.g*., current and voltage) which are deemed to be indicative or not of a holiday.

(Generally, a spike in a signal such as a spark causing the current strength to exceed a threshold or baseline would be indicative of a holiday. However, it should be understood that for different signals it is possible that a signal reducing below a threshold would be indicative of a holiday. As such, while the disclosure may generically at times herein refer to exceeding or surpassing a baseline or threshold in reference to detecting a holiday, more precisely when referring to a signal indicating a holiday based on the signal relative to its baseline or threshold, it should be said that a holiday is detected when that signal strength has a value which is on a side of its baseline or threshold [*i.e.,* above or below] which is deemed to be indicative of a holiday.)

Further, the electromagnetic detector 152 may advantageously measure changes in both current and voltage by coupling to the high voltage cable 116 through a winding and toroid 162 of an inductive coupler 154 and through conductive plates 164 of an electric (capacitive) coupler 156. Fig. 8 illustrates such a sensor 100 wherein an inductive coupler 154 with toroid with winding 162 is used to sense current in the high voltage cable 116 and an electric coupling 156 with conductive plates 164 is used to sense voltage. By sensing both current (by measuring the magnetic field) and electric field changes versus time, the sensor 100 can detect smaller fluctuations and is more sensitive to small holidays than with prior art sensors. For example, with each of a plurality of signals being compared its own separate baseline, a holiday can be detected in instances where only one of the signals exceeds its baseline (*e.g.,* in instances in which a holiday may cause a minor change in current but cause a significant and noticeable change in electric field).

It should thus be recognized that the disclosed sensor 100 which measures a plurality of signals (*e.g.,* current and voltage, rather than current alone) may advantageously minimize false positive and false positive signals.

A further advantageous feature of the disclosed sensor 100 is dynamic determination of the threshold(s) of the monitored signal(s) as continuously calculated by the processor 160. In that regard, the sensor 100 includes a high voltage pulse generator 110A, with the holiday detector unit 150 over time detecting a plurality of at least one electric signal associated with the pulsing current. The processor 160 continuously processes the plurality of each signal type (*e.g.,* current or voltage) detected for a recent selected time period (*e.g.,* 30 pulses per second for one second ) and continuously generates and updates a dynamic baseline or threshold for each signal type being detected. Such baseline(s) may be determined using the signals from the recent selected time period by a suitable method, such as energy averaging, filtering, and Fourier spectrum.

Fig. 9 illustrates this function in comparison to the prior art sensors in which the thresholds were manually adjustable but otherwise fixed. In the illustrated example, it can be seen that while the fixed threshold of the prior art is a flat line 180, the dynamic, self-adjusting threshold 182 will change given environmental changes encountered by the movable contact 120 (*e.g.,* different soil resistivity in the area of the movable contact 120 and/or motion of the movable contact 120). Thus, in the prior art, a peak 186 which exceeds the flat line threshold 180 of the prior art would be taken to (falsely) indicate a holiday in the location of the movable contact 120, even though the peak 186 may result from environmental factors in the area of the movable contact 120 and not a holiday. By contrast, with the sensor 100 disclosed here, the processor 160 will dynamically include such factors to create a self-correcting dynamic threshold 182 so that the comparison of the signal to the threshold will factor in environmental factors to avoid false positive signals. Similarly, where the environmental factors will cause a reduction in the signal, the processor 160 as disclosed herein will result in a reduced threshold (or a dip in the threshold) and avoid false negative signals.

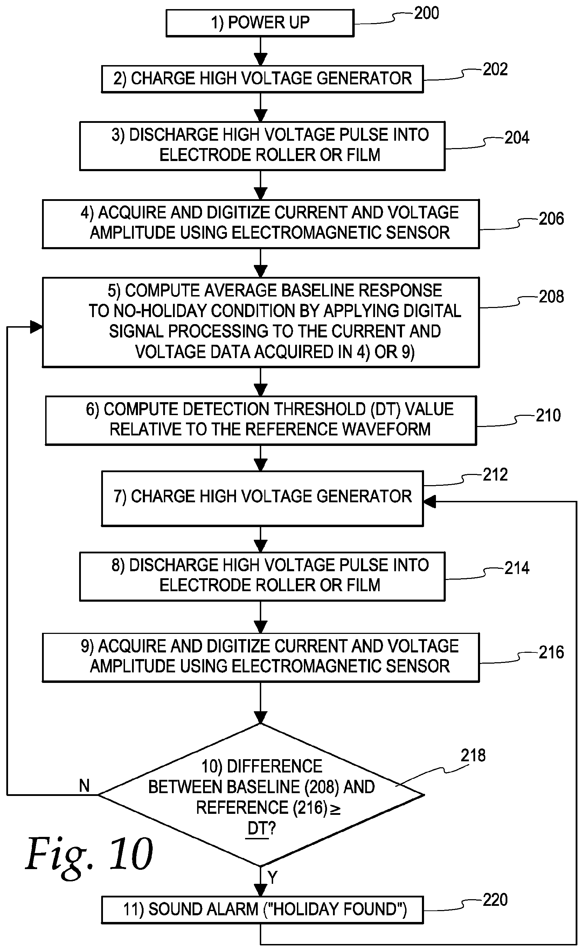

Fig. 10 is a flow chart showing the method of operation of the sensor 100 disclosed herein with both dynamic threshold determination and detection of multiple different signals.

Specifically, the sensor 100 is first turned on (step 200) and the high voltage pulse generator 110A charged (step 202). A high voltage pulse is discharged through the high voltage cable 116 to the movable contact 120 (step 204), and the electromagnetic detector 150A of the holiday detector unit 150 acquires the current and voltage amplitude (step 206) of that pulse, which the processor 160 uses to compute average signal strength indicative of a holiday (step 208). At step 210, the processor 160 uses the computed signal strength from step 208 to compute a detection threshold relative to the electric reference (*e.g.,* ground 14) of the generator 110. The high voltage pulse generator 110A is again charged (step 212) and a pulse discharged to the movable contact 120 (step 214), with the electromagnetic detector 150A of the holiday detector unit 150 acquiring the current and voltage amplitude (step 216) of that pulse. This process of repetitively discharging a high voltage pulse which the electromagnetic detector 150A detects and the processor 160 uses to update the dynamic threshold is repeated over and over until a determined amount of pulse data has been acquired, at which point when another pulse is added to the data, data for the oldest pulse is excluded from the average computed in step 208. Operation then continues in that manner until the processor 160 determines that a pulse has exceeded the current computed detection threshold (*e.g.,* current and/or voltage amplitude), in which case an alarm or location indicator 144 is sent.

The sensor 100 may advantageously allow the operator to control the high voltage pulsing such as described above by depressing a suitable trigger switch when such pulsing is desired (at step 200 initially, and later at step 212 when enough data has been acquired).

The location indicator 144 may be a conventional audible alarm included with the holiday detector unit 150 which sounds when a holiday is detected (the sound thereby alerting the operator that a holiday is present at the location of the movable contact 120), and/or may also include any suitable signal, including visual signals *(e.g.,* a light) or a digital signal marking the location of the movable contact 120 (and thus the holiday) on the grid.

With an understanding of the above disclosure, it should be recognized that detection of holidays in liners *(e.g.,* geomembranes) may be advantageously, easily and reliably accomplished, with minimal false positive and/or false negative indications.

## Claims

1. A sensor (100) for detecting holidays in a liner (124), comprising:
a high voltage pulsing generator (110A) with an electric reference;
an electrode (120) adapted to move over and maintain contact with the liner (124) spaced from said generator electric reference while said generator (110A) pulses current to said electrode (120);
a processor (160) adapted to:
detect both current strength and voltage;
detect over time from said generator electric reference at least one electric signal associated with said pulsing current;
continuously process current strength to generate a baseline of current strength;
continuously process voltage to generate a baseline of voltage;
continuously process for a recent selected time period the at least one electric signal detected during said selected time period, and
generate a baseline of said at least one electrical signal, wherein a detected electric signal having a value on one side of the baseline is deemed to indicate no holiday and an electric signal having a value on the other side of the baseline is deemed to indicate a holiday; and
a holiday signal actuated when any detected electric signal has a value on said other side of said baseline,
wherein said holiday signal is actuated when either of said detected current strength or detected voltage is on the other side of its generated baseline.

2. The sensor (100) of claim 1, wherein said processor (160) is adapted to use at least one of energy averaging, filtering, and Fourier spectrum to generate the baseline from the recent plurality of detected electric signals.

3. The sensor (100) of claim 1, wherein said actuated holiday signal is at least one of an audible sound and a warning light.

4. The sensor (100) of claim 1, wherein said holiday signal is a location indication corresponding to the area of the liner being contacted by the electrode at the time the detected electric signal value is on said other side of said baseline.

5. The sensor (100) of claim 1, wherein the electrode (120) is adapted to maintain a uniform contact with the liner (124) in areas which are not flat but have rolling contours.

6. The sensor (100) of claim 1, wherein said electrode (120) comprises:
a truck (130) rolling on guide wheels (132);
a flexible conductive cable (134) supported between said guide wheels (132); and
a plurality of conductive rollers (136) spaced along said cable (134) wherein each roller (136) is rotatable about said cable (134).

7. The sensor (100) of claim 1, wherein said electrode (120) is a flexible conductive sheet (120B).

8. The sensor (100) of claim 1, wherein said electrode (120) is a flexible chain mail (120A).

9. A method of detecting holidays in a liner (124) using the sensor (100) according to any one of the preceding claims, said method comprising the steps of:
turning on the sensor (200);
charging the high voltage pulsing generator (202)
pulsing current from said generator to the electrode as said electrode is moved over said liner (204);
detecting a plurality of at least one electric signal associated with said pulsing current from said electric reference (206);
continuously processing a selected recent plurality of said detected electric signals to generate a baseline value for said at least one electrical signal, wherein a detected electric signal having a value on one side of the baseline is deemed to indicate no holiday and an electric signal having a value on the other side of the baseline is deemed to indicate a holiday; and
actuating a holiday signal when at least one of said detected electric signals has a value on said other side of said baseline.

## Patentansprüche

1. Sensor (100) zur Detektion von Löchern in einer Abdichtungsbahn (124), umfassend:
einen Hochspannungspulsgenerator (110A) mit einer elektrischen Referenz;
eine Elektrode (120), die ausgelegt ist, um sich über der von der elektrischen Referenz des Generators beabstandeten Abdichtungsbahn (124) zu bewegen und den Kontakt mit dieser aufrechtzuerhalten, während der Generator (110A) die Elektrode (120) mit gepulstem Strom versorgt;
einen Prozessor (160), der ausgelegt ist, um:
sowohl die Stromstärke als auch die Spannung zu detektieren;
über die Zeit hinweg von der elektrischen Referenz des Generators mindestens ein elektrisches Signal zu detektieren, das mit dem gepulsten Strom assoziiert ist;
kontinuierlich Stromstärke zu verarbeiten, um einen Stromstärkenbasiswert zu erzeugen;
kontinuierlich Spannung zu verarbeiten, um einen Spannungsbasiswert zu erzeugen;
das mindestens eine, während des ausgewählten Zeitraums detektierte elektrische Signal für einen jüngsten ausgewählten Zeitraum kontinuierlich zu verarbeiten und einen Basiswert des mindestens einen elektrischen Signals zu erzeugen, wobei ein detektiertes elektrisches Signal, das einen Wert auf einer Seite des Basiswerts aufweist, als Hinweis darauf gilt, dass kein Loch vorliegt, und ein elektrisches Signal, das einen Wert auf der anderen Seite des Basiswerts aufweist, als Hinweis auf ein Loch gilt, und
ein Lochsignal, das ausgelöst wird, wenn ein detektiertes elektrisches Signal einen Wert auf der anderen Seite aufweist,
wobei das Lochsignal ausgelöst wird, wenn sich entweder die detektierte Stromstärke oder die detektierte Spannung auf der anderen Seite ihres erzeugten Basiswerts befindet.

2. Sensor (100) nach Anspruch 1, wobei der Prozessor (160) ausgelegt ist, um mindestens entweder Energiemittelwertbildung, Filterung und/oder Fourier-Spektrum zu verwenden, um den Basiswert aus der jüngsten Vielzahl von detektierten elektrischen Signalen zu erzeugen.

3. Sensor (100) nach Anspruch 1, wobei das ausgelöste Lochsignal mindestens entweder ein hörbares Geräusch und/oder ein Warnlicht ist.

4. Sensor (100) nach Anspruch 1, wobei das Lochsignal eine Standortangabe entsprechend dem durch die Elektrode berührten Bereich der Abdichtungsbahn ist, zu dem Zeitpunkt, an dem der Wert des detektierten elektrischen Signals auf der anderen Seite des Basiswerts ist.

5. Sensor (100) nach Anspruch 1, wobei die Elektrode (120) ausgelegt ist, um in Bereichen, die nicht eben sind, sondern gekrümmte Konturen aufweisen, einen gleichmäßigen Kontakt mit der Abdichtungsbahn (124) aufrechtzuerhalten.

6. Sensor (100) nach Anspruch 1, wobei die Elektrode (120) Folgendes umfasst:
einen Wagen (130), der auf den Führungsrädern (132) verfährt;
ein flexibles leitendes Kabel (134), das zwischen den Führungsrädern (132) gestützt wird, und
eine Vielzahl von leitenden Rollen (136), die entlang des Kabels (134) beabstandet sind, wobei eine jede Rolle (136) um das Kabel (134) drehbar ist.

7. Sensor (100) nach Anspruch 1, wobei die Elektrode (120) ein flexibles leitendes Blech (120B) ist.

8. Sensor (100) nach Anspruch 1, wobei die Elektrode (120) ein flexibles Kettengeflecht (120A) ist.

9. Verfahren zur Detektion von Löchern in einer Abdichtungsbahn (124) unter Nutzung des Sensors (100) nach einem der vorhergehenden Ansprüche, wobei das Verfahren die folgenden Schritte umfasst:
Einschalten des Sensors (200);
Laden des Hochspannungspulsgenerators (202) Pulsieren des Stroms von dem Generator zu der Elektrode, wenn die Elektrode über der Abdichtungsbahn (204) bewegt wird;
Detektieren einer Vielzahl von mindestens einem elektrischen Signal, das mit dem gepulsten Strom assoziiert ist, von der elektrischen Referenz (206);
kontinuierliches Verarbeiten einer ausgewählten jüngsten Vielzahl der detektierten elektrischen Signale, um einen Basiswert für das mindestens eine elektrische Signal zu erzeugen, wobei ein detektiertes elektrisches Signal, das einen Wert auf einer Seite des Basiswerts aufweist, als Hinweis darauf gilt, dass kein Loch vorliegt, und ein elektrisches Signal, das einen Wert auf der anderen Seite des Basiswerts aufweist, als Hinweis auf ein Loch gilt, und
Auslösen eines Lochsignals, wenn mindestens eines der detektierten elektrischen Signale einen Wert auf der anderen Seite des Basiswerts aufweist.

## Revendications

1. Capteur (100) pour détecter des fuites dans une membrane d'étanchéité (124), comprenant :
un générateur d'impulsions haute tension (110A) avec une référence électrique ;
une électrode (120) adaptée pour se déplacer sur et maintenir le contact avec la membrane d'étanchéité (124) espacée par rapport à ladite référence électrique du générateur tandis que ledit générateur (110A) pulse du courant vers ladite électrode (120) ;
un processeur (160) adapté pour :
détecter à la fois l'intensité du courant et la tension ;
détecter dans le temps à partir de ladite référence électrique du générateur au moins un signal électrique associé audit courant pulsé ;
traiter en continu l'intensité du courant pour générer une ligne de base de l'intensité du courant ;
traiter en continu la tension pour générer une ligne de base de tension ;
traiter en continu pendant une période de temps sélectionnée récente le au moins un signal électrique détecté pendant ladite période de temps sélectionnée, et générer une ligne de base dudit au moins un signal électrique, dans lequel un signal électrique détecté ayant une valeur d'un côté de la ligne de base est réputé n'indiquer aucune fuite et un signal électrique ayant une valeur de l'autre côté de la ligne de base est réputé indiquer une fuite ; et
un signal de fuite déclenché lorsqu'un signal électrique détecté a une valeur dudit autre côté de ladite ligne de base,
dans lequel ledit signal de fuite est déclenché lorsque l'une ou l'autre de ladite intensité de courant détectée ou de ladite tension détectée est de l'autre côté de sa ligne de base générée.

2. Capteur (100) selon la revendication 1, dans lequel ledit processeur (160) est adapté pour utiliser au moins l'un d'un moyennage d'énergie, d'un filtrage et d'un spectre de Fourier pour générer la ligne de base à partir de la pluralité récente de signaux électriques détectés.

3. Capteur (100) selon la revendication 1, dans lequel ledit signal de fuite déclenché est au moins l'un d'un son audible et d'un voyant d'avertissement.

4. Capteur (100) selon la revendication 1, dans lequel ledit signal de fuite est une indication d'emplacement correspondant à la zone de la membrane d'étanchéité étant en contact avec l'électrode au moment où la valeur de signal électrique détectée se trouve dudit autre côté de ladite ligne de base.

5. Capteur (100) selon la revendication 1, dans lequel l'électrode (120) est adaptée pour maintenir un contact uniforme avec la membrane d'étanchéité (124) dans des zones qui ne sont pas plates mais qui ont des contours ondulés.

6. Capteur (100) selon la revendication 1, dans lequel ladite électrode (120) comprend :
un chariot (130) roulant sur des roues de guidage (132) ;
un câble conducteur flexible (134) supporté entre lesdites roues de guidage (132) ; et
une pluralité de rouleaux conducteurs (136) espacés le long dudit câble (134), dans lequel chaque rouleau (136) peut tourner autour dudit câble (134).

7. Capteur (100) selon la revendication 1, dans lequel ladite électrode (120) est une feuille conductrice flexible (120B).

8. Capteur (100) selon la revendication 1, dans lequel ladite électrode (120) est un treillis d'anneaux métalliques flexible (120A).

9. Procédé de détection de fuites dans une membrane d'étanchéité (124) à l'aide du capteur (100) selon l'une quelconque des revendications précédentes, ledit procédé comprenant les étapes de :
allumer le capteur (200) ;
charger le générateur d'impulsions haute tension (202) pulser du courant dudit générateur à l'électrode lorsque ladite électrode est déplacée sur ladite membrane d'étanchéité (204) ;
détecter une pluralité d'au moins un signal électrique associé audit courant pulsé à partir de ladite référence électrique (206) ;
traiter en continu une pluralité récente sélectionnée desdits signaux électriques détectés pour générer une ligne de base pour ledit au moins un signal électrique, dans lequel un signal électrique détecté ayant une valeur d'un côté de la ligne de base est réputé n'indiquer aucune fuite et un signal électrique ayant une valeur de l'autre côté de la ligne de base est réputé indiquer une fuite ; et
déclencher un signal de fuite lorsqu'au moins un desdits signaux électriques détectés a une valeur dudit autre côté de ladite ligne de base.
